(19) Europäisches Patentamt
European Patent Office
Office européen des brevets

(11) **EP 4 266 069 B1**

(12) **EUROPEAN PATENT SPECIFICATION**

(45) Date of publication and mention
of the grant of the patent:
**10.09.2025 Bulletin 2025/37**

(21) Application number: **22896163.7**

(22) Date of filing: **21.11.2022**

(51) International Patent Classification (IPC):
**G01R 31/392** (2019.01)   **G01R 31/382** (2019.01)
**G01R 31/367** (2019.01)   **H02J 7/00** (2006.01)
**H01M 10/052** (2010.01)

(52) Cooperative Patent Classification (CPC):
**H02J 7/005; G01R 31/392;** G01R 31/367;
G01R 31/382; H01M 10/052; Y02E 60/10

(86) International application number:
**PCT/KR2022/018402**

(87) International publication number:
**WO 2023/090966 (25.05.2023 Gazette 2023/21)**

(54) **METHOD FOR ESTIMATING STATE OF HEALTH OF LITHIUM-SULFUR BATTERY**

VERFAHREN ZUR SCHÄTZUNG DES GESUNDHEITSZUSTANDS EINER
LITHIUM-SCHWEFEL-BATTERIE

PROCÉDÉ D'ESTIMATION DE L'ÉTAT DE SANTÉ DE BATTERIE AU LITHIUM-SOUFRE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **22.11.2021 KR 20210160919**

(43) Date of publication of application:
**25.10.2023 Bulletin 2023/43**

(73) Proprietor: **LG Energy Solution, Ltd.
Seoul 07335 (KR)**

(72) Inventors:
• **AHN, Jihoon**
 **Daejeon 34122 (KR)**
• **KIM, Bong Soo**
 **Daejeon 34122 (KR)**
• **HAN, Dong Hyeop**
 **Daejeon 34122 (KR)**

(74) Representative: **Goddar, Heinz J.
Boehmert & Boehmert
Anwaltspartnerschaft mbB
Pettenkoferstrasse 22
80336 München (DE)**

(56) References cited:
WO-A1-2016/166555    WO-A1-2019/240225
CN-B- 107 102 263    KR-A- 20120 071 600
KR-A- 20160 079 637    KR-A- 20160 103 331
KR-A- 20210 074 004    KR-B1- 101 922 478
US-A1- 2013 066 573    US-A1- 2021 255 246

• **SHATERI NEDA ET AL: "An Experimental Study
on Prototype Lithium-Sulfur Cells for Aging
Analysis and State-of-Health Estimation", IEEE
TRANSACTIONS ON TRANSPORTATION
ELECTRIFICATION, IEEE, vol. 7, no. 3, 16
February 2021 (2021-02-16), pages 1324 - 1338,
XP011872870, DOI: 10.1109/TTE.2021.3059738**

**Description**

[Technical Field]

The present invention relates to a method of estimating a state of health of a lithium-sulfur battery.

[Background Art]

Recently, as mobile electronic devices, electric vehicles, and large-capacity power storage systems, and the like develop, the need for large-capacity batteries is rising up. Lithium-sulfur batteries are secondary batteries that use a sulfur-based material having a sulfur-sulfur bond (S-S bond) as a cathode active material and use a lithium metal as an anode active material, and sulfur, which is a main material of the cathode active material, has advantages in that it is very abundant in resources, non-toxic, and has a low weight per atom.

A theoretical discharging capacity of the lithium-sulfur batteries is 1672 mAh/g-sulfur, and a theoretical energy density of the lithium-sulfur batteries is 2,600 Wh/kg, which is very high compared to theoretical energy densities of other battery systems that are currently being studied. Therefore, the lithium-sulfur batteries have attracted attention as batteries having high energy density characteristics.

A typical lithium-sulfur battery includes an anode formed of a lithium metal or a lithium metal alloy and a cathode formed of elemental sulfur or other electroactive sulfur materials.

The sulfur at the cathode of the lithium-sulfur battery is reduced in two steps when the lithium-sulfur battery is discharged. In a first step, sulfur (e.g., the elemental sulfur) is reduced to lithium polysulfide ($Li_2S_8$, $Li_2S_6$, $Li_2S_5$, or $Li_2S_4$). These species are generally dissolved in an electrolyte solution. In a second step, the lithium polysulfide is reduced to $Li_2S$ that may be deposited on a surface of the anode. Conversely, when the lithium-sulfide battery is charged, $Li_2S$ is oxidized to lithium polysulfide ($Li_2S_8$, $Li_2S_6$, $Li_2S_5$, or $Li_2S_4$), and then oxidized to lithium and sulfur.

Like a general battery, the lithium-sulfur battery is gradually deteriorated as it is repeatedly charged and discharged. Even though the deteriorated battery is fully charged up to a voltage limit, a usable capacity is smaller than an initial usable capacity, and a ratio of a current usable capacity to the initial usable capacity may be expressed as a state of health.

The state of health may be theoretically calculated by the following Equation.

$$\text{SoH \%} = [C_{(det)} / C_{(ini)}] \times 100$$

Here, $C_{(det)}$ refers to a usable capacity of the battery after being deteriorated, and $C_{(ini)}$ refers to an initial usable capacity of the battery (usable capacity of the before being deteriorated)

Such state of health (SoH) information of the battery enables a user to establish an appropriate battery use plan, and accordingly, enables improvement of use efficiency, reliability, and safety of the battery.

Meanwhile, the $C_{(det)}$ may be calculated by completely discharging a buffered battery and measuring a quantity of electric charge, but since there are not many situations in which the battery is fully charged and completely discharged in an actual use environment of the battery, it is not practical to estimate the SoH by the above-described method.

Therefore, the development of a method capable of practically and reliably estimating the SoH has been required. In particular, the lithium-sulfur battery has a chemical behavior different from that of other lithiumion batteries, and thus, the development of a method of estimating a SoH of the lithium-sulfur battery appropriate for such characteristics has been required.

WO 2016/166555 A1 discloses systems and methods for accurately determining the state of health (including state of charge and relative age) of a Lithium Sulfur battery, module or cell. The disclosure uses an operational model of a Lithium Sulfur cell or battery to predict model parameters under a range of conditions related to state of charge and state of health. Operational models include the memory effect due to the unique chemistry of a Lithium Sulfur cell that precludes the use of other methodologies for State of health determination for Lithium Sulfur batteries. Model parameters are identified in real life applications and parameters are compared to those of the operational Lithium Sulfur model employing Kalman filtering. The output includes an estimate of state of health and other key performance indicators. Key performance indicators are compared with measured values of for example resistance to provide feedback to the estimation process in order to improve accuracy. The system can be implemented as software or firmware in an application. WO 2019/240225 A1 discloses is an estimation device that estimates a degradation state of a power storage element including, in a positive electrode and/or a negative electrode, an active material indicating a hysteresis between a power storage amount-voltage charging property and a power storage amount-voltage discharging property. The estimation device comprises a first acquisition unit that acquires a voltage variation that is a difference between a first voltage of the power storage element at the time of suspension of charging and a second voltage of the storage element after elapse of a predetermined time during which the suspension of charging continues, and an estimation unit that estimates the degradation state of the power storage element on the basis of the voltage variation amount. The estimation amount estimates the degradation state of the power storage element on the basis of a decrease in the voltage variation amount.

[Disclosure]

[Technical Problem]

The present invention is devised to solve the above problems in the related art, and it is an object of the present invention to provide a method of estimating a state of health (SoH) of a lithium-sulfur battery capable of quickly and reliably estimating the state of health of the lithium-sulfur battery in a simple manner.

It is another object of the present invention to provide a method of estimating a state of health of a lithium-sulfur battery that can be practically used.

[Technical Solution]

In order to achieve the above objects,

the present invention is a method of confirming a deterioration state of the lithium-sulfur battery, and provides a method of estimating a state of health (SoH) of a lithium-sulfur battery, including the steps of:

a) maintaining a battery, which is fully charged and for which a SoH is to be confirmed, in a rest state for 0.01 seconds or more in a state in which the battery (for which the SoH is to be confirmed) is fully charged;
b) measuring $OCV_{(det)}$ in a state in which a voltage drop is made during the rest state;
c) calculating $\Delta OCV$ by subtracting $OCV_{(det)}$ from $OCV_{(ini)}$ previously measured in the same manner as in steps a) and b) at an initial stage of use of the battery (for which the SoH is to be confirmed) ; and
d) estimating a state of health (%) of the battery (for which the SoH is to be confirmed) from a magnitude of $\Delta OCV$.

[Advantageous Effects]

With the method of estimating a state of health (SoH) of a lithium-sulfur battery of the present invention, a method of quickly and reliably estimating the state of health of the lithium-sulfur battery in a simple manner is provided.

In addition, a method estimating a state of health of a lithium-sulfur battery capable of being practically used is provided.

[Description of Drawings]

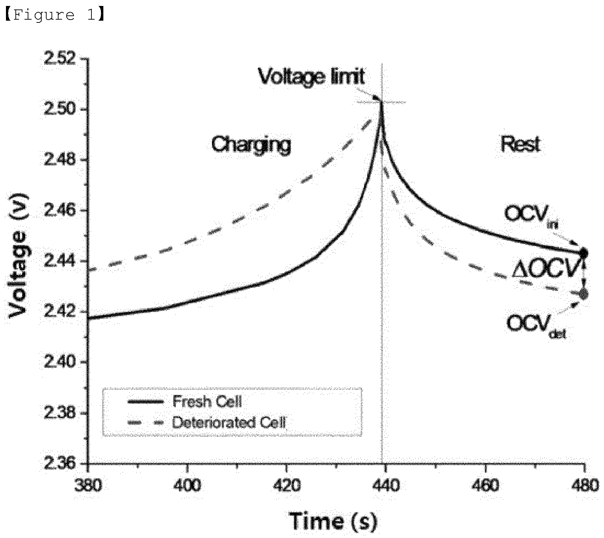

FIG. 1 is graphs showing the voltage drops during a rest period after full charging of a fresh lithium-sulfur battery and a deteriorated lithium-sulfur battery.

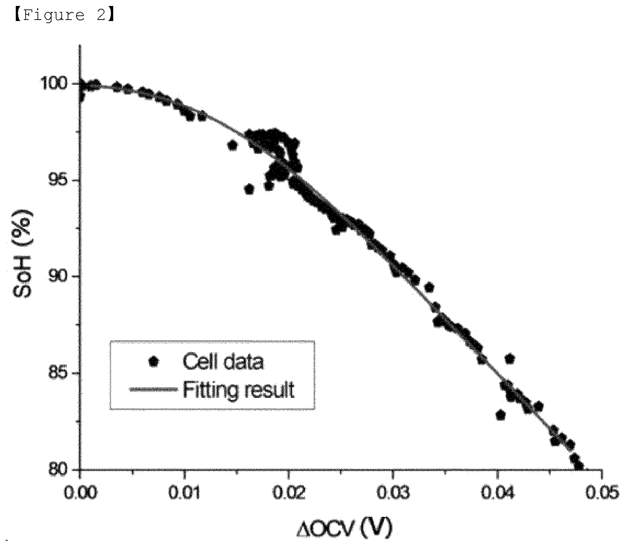

FIG. 2 is graphs obtained by obtaining state of health (%) (SoH (%)) data of a lithium-sulfur battery in each charging/discharging cycle while repeatedly fully charging and fully discharging the lithium-sulfur battery and β data at a predetermined point in time during a rest period after charging of the lithium-sulfur battery, showing SoH (%) on a y-axis and showing β on an x-axis, and fitting the data obtained above with a specific function.
(β: OCV obtained by subtracting $OCV_{(det)}$ measured at a predetermined point in time during a rest period after full charging of the lithium-sulfur battery in each cycle from $OCV_{(ini)}$ measured at a predetermined point in time during the rest period after full charging of the battery when charging of the battery in an initial cycle)

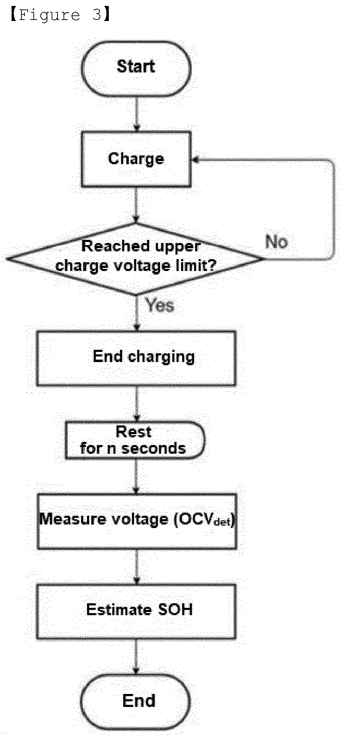

FIG. 3 is a flowchart showing a method of estimating a state of health according to the present invention.

[Best Mode]

Hereinafter, preferred embodiments of the present invention will be described in detail with reference to the accompanying drawings.

The following description and drawings illustrate specific embodiments to enable those skilled in the art to easily practice a device and method to be described.

When a lithium-sulfur battery is charged up to an upper limit voltage and thus charging ends, and enters a rest period, a voltage drop occurs. Such a voltage drop is understood as a self-discharging phenomenon caused by a polysulfide shuttle phenomenon unique to the lithium-sulfur battery along with the resolution of charging overvoltage.

As shown in FIG. 1, in the case of a deteriorated battery, as deterioration of the battery progresses, a voltage drop phenomenon appears greater as compared with a fresh battery, and such a phenomenon results from a cause in which a battery resistance is increased due to the deterioration of electrodes and an electrolyte and thus a charging overvoltage is increased, and a cause in which a polysulfide shuttle phenomenon is intensified due to electrolyte deterioration. Therefore, a voltage drop in the rest period after charging of the battery is determined by data providing information on the deterioration of the battery.

The present inventors have completed the present invention using a magnitude (ΔOCV) of the voltage drop in the rest period after charging of the battery as an estimation parameter for a state of health (SoH) of the battery according to the research results as described above.

In the present invention, the state of health of the battery may also be expressed as a deterioration state of the battery.

Hereinafter, the present invention will be described in detail.

The present invention is a method of confirming a deterioration state of the lithium-sulfur battery, and provides a method of estimating a state of health (SoH) of a lithium-sulfur battery, including the steps of:

a) maintaining a battery, which is fully charged and for which a SoH is to be confirmed, in a rest state for 0.01 seconds or more in a state in which the battery (for which the SoH is to be confirmed) is fully charged;
b) measuring $OCV_{(det)}$ in a state in which a voltage drop is made during the rest state;
c) calculating ΔOCV by subtracting $OCV_{(det)}$ from $OCV_{(ini)}$ previously measured in the same manner as in steps a) and b) at an initial stage of use of the battery; and
d) estimating a state of health (%) of the battery from a magnitude of the ΔOCV.

In the present invention, OCV is an acronym of an Open Circuit Voltage, and refers to an open circuit voltage of the battery.

FIG. 2 is graphs obtained by obtaining state of health (%) (SoH (%)) data of a lithium-sulfur battery in each charging/discharging cycle while repeatedly fully charging and fully discharging the lithium-sulfur battery and β data at a predetermined point in time during a rest period after charging of the lithium-sulfur battery and showing SoH (%) on a y-axis and showing β on an x-axis.

As can be seen from FIG. 2, as the deterioration of the battery progresses, since a value of the ΔOCV gradually increases and a magnitude of the value of ΔOCV has a negative correlation with SoH (%), from such a relationship, it is possible to estimate the state of health of the battery from the ΔOCV.

In the present invention, the state of health (%) refers to State of Health (SoH) (%), and also refers to a deterioration state(%) in another meaning. In addition, in the present invention, the OCV refers to an Open Circuit Voltage.

In an embodiment of the present invention, the estimating of the state of health (%) of the battery in step d) may be performed using a negative correlation function between the state of health (%) of the lithium-sulfur battery and the magnitude of ΔOCV. The negative correlation function refers to, for example, a function expressing a relationship in which a value of SoH (%) becomes smaller as ΔOCV increases in a relationship between SoH (%) and ΔOCV.

The negative correlation function may be expressed as SoH (%) = f(ΔOCV).

In an embodiment of the present invention, the estimating of the state of health (%) of the battery in step d) may be performed by a method of comparing the measured ΔOCV with a state of health (%) mapping reference of the battery prepared in advance and corresponding to the magnitude of ΔOCV.

In an embodiment of the present invention, the state of health (%) mapping reference of the battery corresponding to the magnitude of ΔOCV may be data created by repeating full charging and full discharging of a battery manufactured in the same manner as the battery (for which the SoH is to be confirmed) to obtain state of health (%) (SoH (%)) data of the battery according to Equation 1 in each charging/discharging cycle, obtaining ΔOCV data in the same manner as above, and matching these data in a one-to-one manner.

[Equation 1]

$$SoH\ (\%) = [C_{(det)}/C_{(ini)}] \times 100$$

$C_{(ini)}$: usable capacity before deterioration, $C_{(det)}$: usable capacity after deterioration

Wherein, the usable capacity may be obtained by completely discharging the fully charged battery and measuring a quantity of electric charge, as known in the art. Specifically, for example, the usable capacity of the battery before deterioration and the usable capacity of the battery after deterioration may be calculated by repeatedly performing a cycle of applying a current having a magnitude of 0.2C to the battery so that a battery voltage becomes 2.5V to charge the battery, discharging the battery with a current having a magnitude of 0.3C until the battery voltage reaches 1.8V, and measuring a quantity of electric charge obtained when discharging the battery. However, the usable capacity is not limited to this method, and may be calculated using a method known in the art.

In an embodiment of the present invention, the state of health mapping reference may be, for example, a graph showing SoH (%) on the y-axis and the magnitude of $\Delta$OCV on the x-axis, or a lookup table in which SoH (%) and the magnitude of $\Delta$OCV corresponding to SoH (%) are matched in a one-to-one manner.

In an embodiment of the present invention, a rest state maintaining period in step a) may be 0.01 second or more, preferably 0.05 second or more, and more preferably 0.1 second or more. When the rest state maintaining period is less than 0.01 second, it may be difficult to estimate the state of health (%) of the battery due to a small difference in the magnitude of $\Delta$OCV according to the deterioration state of the battery, and the accuracy of estimation may also be decreased.

The rest state maintaining period may be 0.01 second to 3 minutes, preferably 0.01 second to 2 minutes, more preferably 0.01 second to 1 minute, and even more preferably 0.01 second to 30 seconds. When the rest state maintaining period exceeds 3 minutes, it is not preferable because it takes too long time to estimate SoH (%) and it is difficult to estimate SoH (%) in real time.

In an embodiment of the present invention, the "initial stage" in step c) may be from a first use of the battery to a point in time when a deterioration rate of the battery is within 10%, preferably from a first use of the battery to a point in time when a deterioration rate of the battery is within 5%, 3%, or 1%, and more preferably a first use point in time of the battery.

In an embodiment of the present invention, the estimating of the state of health (%) of the battery from the magnitude of $\Delta$OCV in step d) may be performed by a method of obtaining a scatter plot graph using state of health (%) data of a battery obtained in each cycle by repeating full charging and full discharging for the battery manufactured in the same manner as the battery (for which the SoH is to be confirmed) as a y-axis value and using $\Delta$OCV data obtained in the same manner as the above as an x-axis value, obtaining a fitting function by applying the least squares method to the scatter plot graph, and substituting $\Delta$OCV obtained from the battery (for which the SoH is to be confirmed) into the fitting function.

In an embodiment of the present invention, the estimating of the state of health (%) of the battery from the magnitude of $\Delta$OCV in step d) may be performed by the following Equation 2:

[Equation 2]

$$\text{SoH(\%)} = \sum_{i=1}^{j} \left[ a_i \left( OCV_{(ini)} - OCV_{(det)} \right)^i \right] + c$$

wherein,

$OCV_{(ini)}$ is OCV measured after the battery is maintained in the rest state for 0.01 seconds or more in the state in which the battery is fully charged at the initial stage of the use of the battery,
$OCV_{(det)}$ is OCV measured after the battery (for which the SoH is to be confirmed) is maintained in the rest state for the same period as the rest state maintaining period in the state in which the battery (for which the SoH is to be confirmed) is fully charged,
j is the highest dimension of a polynomial function,
$a_i$ is a coefficient of an i-th order term, and
c is a value of SoH (%) corresponding to $OCV_{(ini)}$.

Wherein, j may be 2 to 10, and preferably 3 to 5.

Wherein, $a_i$ and c may be changed depending on various design factors of a cell, but it may be assumed that $a_i$ and c have the same values for the same design. Accordingly, when the $a_i$ and c are obtained through an experiment on the manufactured battery, the state of health (%) of the battery may be very simply and reliably estimated by calculating $\Delta$OCV of the battery.

The $a_i$ is a coefficient of each order term in a polynomial function having an arbitrarily set highest order term j by applying the least squares method to the scatter plot graph plotted using the state of health (%) data of the battery obtained in each cycle by repeating full charging and full discharging for the battery manufactured in the same manner as the battery (for which the SoH is to be confirmed) as the y-axis value and using the $\Delta$OCV data obtained in the same manner as the above as the x-axis value and. The least squares method is a method well known to those skilled in the art.

In the above, j may be arbitrarily set in the range of 2 to 10 and preferably 3 to 5 so that an adjusted R-squared (Adj. $R^2$) after fitting has a value of 0.90 or more, preferably 0.95 or more, and more preferably 0.98 or more.

Equation 2 may be expressed as Equation 3.

[Equation 3]

$$SoH(\%) = \sum_{i=1}^{j} (a_i \times \triangle OCV^i) + C$$

FIG. 3 is a flowchart showing a method of estimating a state of health of a lithium-sulfur battery according to the present invention. According to the present invention, the state of health of the battery may be practically and reliably provided by a simple method as shown in FIG. 3.

[Mode for Invention]

Hereinafter, preferred examples will be provided in order to help understand the present invention. However, it will be obvious to those skilled in the art that the following Examples are only an example of the present invention and various modifications and alterations may be made without departing from the scope and spirit of the present invention. In addition, it is natural that these modifications and alterations will fall within the appended claims.

**Example 1: Estimation of state of health of lithium-sulfur battery**

State of health (%) (SoH (%)) data and $\triangle OCV$ data of a lithium-sulfur battery in each charging/discharging cycle were obtained while repeating full charging and full discharging of the lithium-sulfur battery that was not used.
Specifically, the SoH (%) data in each cycle was obtained by the following Equation 1:

[Equation 1]

$$SoH\ (\%) = [C_{(det)}/C_{(ini)}] \times 100$$

$C_{(ini)}$: usable capacity of the battery before deterioration, and $C_{(det)}$: usable capacity of the battery after deterioration.
Specifically, the SoH (%) data was obtained by calculating the usable capacity of the battery before being deteriorated and the usable capacity of the battery after being deteriorated by repeatedly performing a cycle of applying a current having a magnitude of 0.2C to the battery so that a battery voltage becomes 2.5V to charge the battery, discharging the battery with a current having a magnitude of 0.3C until the battery voltage reaches 1.8V, and measuring a quantity of electric charge obtained when discharging the battery.
In addition, the $\triangle OCV$ data was obtained by first fully charging the battery in a first cycle, maintaining the battery in a rest state for 10 seconds, measuring OCV in a state in which a voltage drop is made to obtain $OCV_{(ini)}$, and thereafter fully charging the battery in each cycle, maintaining the battery in a rest state for 10 seconds, measuring each OCV in a state in which a voltage drop is made to obtain each $OCV_{(det)}$, and then subtracting each $OCV_{(det)}$ from $OCV_{(ini)}$ to calculate $\triangle OCV$ in each cycle.
As a result of showing the SoH (%) data obtained in each cycle on the y-axis and showing $\triangle OCV$ on the x-axis, the scatter plot graph as shown in FIG. 2 was obtained. It can be seen from the graph of FIG. 2 that a magnitude of a value of $\triangle OCV$ has a negative correlation with a value of SoH (%) and such a graph may be used as a mapping reference for confirming a battery in comparison to $\triangle OCV$ of the battery (for which the SoH is to be confirmed) measured at a predetermined point in time.
Therefore, if using such a mapping reference, when $\triangle OCV$ of the battery (for which the SoH is to be confirmed) at a predetermined point in time is calculated, the SoH (%) may be easily calculated by comparing a value of the $\triangle OCV$ with the mapping reference.

**Example 2: Estimation of state of health of lithium-sulfur battery**

A $\triangle OCV$ function for SoH (%) corresponding to the graph of FIG. 2 obtained in Example 1 was designed as follows.

[Equation 2]

$$\mathrm{SoH(\%)} = \sum_{i=1}^{j} \left[ a_i \left( OCV_{(ini)} - OCV_{(det)} \right)^{i} \right] + c$$

Wherein,

$OCV_{(ini)}$ is OCV measured after the battery is maintained in a rest state for 0.01 second or more in a first cycle,
$OCV_{(det)}$ is OCV measured after a battery is maintained in a rest state for 10 seconds in a state in which the battery (for which the SoH is to be confirmed) is fully charged,
j is the highest dimension of a polynomial function,
$a_i$ is a coefficient of an i-th order term, and
c is a value of SoH (%) corresponding to $OCV_{(ini)}$.

In the function, $a_i$ is a coefficient of each order term in a polynomial function having an arbitrarily set highest order term j by applying the least squares method to a scatter plot of Example 1, and it was confirmed that the polynomial function fitted as such was fitted to the scatter plot graph obtained in Example 1 in a state in which it has a very high adjusted R-squared (Adj. $R^2$ = 0.983), as illustrated in FIG. 2.

In the above, $a_i$ and c may be changed depending on various design factors of a cell, but it may be assumed that $a_i$ and c have the same values for the same design.

Therefore, it can be seen from the fitting result that when the function of Equation 2 is used, SoH (%) may be very simply obtained by obtaining $\Delta OCV$ at a predetermined point in time for the battery.

## Claims

1. A method of estimating a state of health, SoH, of a lithium-sulfur battery, comprising the steps of:

   a) maintaining a battery, which is fully charged and for which a SoH is to be confirmed, in a rest state for 0.01 seconds or more;
   b) measuring an Open Circuit Voltage, $OCV_{(get)}$ in a state in which a voltage drop is made during the rest state;
   c) calculating $\Delta OCV$ by subtracting the $OCV_{(det)}$ from $OCV_{(ini)}$, where $OCV_{(ini)}$ has been previously measured in the same manner as in steps a) and b) at an initial stage of use of said battery; and
   d) estimating a SoH [%] of said battery from a magnitude of the $\Delta OCV$.

2. The method according to claim 1, wherein the estimating of the SoH [%] of said battery in step d) is performed using a negative correlation function between the SoH [%] of said battery and the magnitude of $\Delta OCV$.

3. The method according to claim 1, wherein the estimating of the SoH [%] of said battery in step d) is performed by a method of comparing the measured $\Delta OCV$ with a SoH mapping reference of said battery prepared in advance and corresponding to the magnitude of $\Delta OCV$.

4. The method according to claim 3, wherein the SoH mapping reference of said battery corresponding to the magnitude of $\Delta OCV$ is data created by repeating full charging and full discharging of another battery manufactured in the same manner as said battery to obtain SoH data of said other battery according to Equation 1 in each charging/discharging cycle,

   obtaining $\Delta OCV$ data in the same manner as the above manner, and
   matching these data to each other in a one-to-one manner,

[Equation 1]

$$SoH\ [\%] = \left[ C_{(det)} / C_{(ini)} \right] \times 100$$

wherein $C_{(ini)}$ refers to a usable capacity of the battery before being deteriorated, and $C_{(det)}$ refers to a usable capacity of the battery after being deteriorated.

**5.** The method according to claim 4, wherein the SoH mapping reference is a graph showing SoH on a y-axis and the magnitude of $\Delta OCV$ on an x-axis or a lookup table in which SoH and the magnitude of $\Delta OCV$ corresponding to SoH are matched to each other in a one-to-one manner.

**6.** The method according to claim 1, wherein the initial stage in step c) is from a first use of said battery to a point in time when a deterioration rate of the battery is within 10%.

**7.** The method according to claim 1, wherein the estimating of the SoH [%] of said battery from the magnitude of $\Delta OCV$ in step d) is performed by a method of:

obtaining a scatter plot graph using SoH data of another battery manufactured in the same manner as said battery, wherein the SoH data of the other battery is obtained in each cycle by repeating full charging and full discharging for the battery as a y-axis value and using $\Delta OCV$ data obtained in the same manner as the above manner as an x-axis value,
obtaining a fitting function by applying the least squares method to the scatter plot graph, and
substituting $\Delta OCV$ obtained from the lithium-sulfur battery into the fitting function.

**8.** The method according to claim 1, wherein the estimating of the SoH [%] of said battery from the magnitude of $\Delta OCV$ in step d) is performed by the following Equation 2:

**[Equation 2]**

$$SoH \ [\%] = \sum_{i=1}^{j} \left[ a_i \left( OCV_{(ini)} - OCV_{(det)} \right)^i \right] + c$$

wherein,

$OCV_{(ini)}$ is an open circuit voltage measured after said battery is maintained in the rest state for a period of 0.01 seconds or more at the initial stage of the use of said battery,
the $OCV_{(det)}$ is the open circuit voltage measured after said battery is maintained in the rest state for said same period as the rest state maintaining period in the state in which said battery is fully charged,
j is the highest dimension of a polynomial function,
$a_i$ is a coefficient of an $i$-th order term, and
c is a value of SoH [%] corresponding to $OCV_{(ini)}$.

**9.** The method according to claim 1, the rest state in step a) is maintained for 0.01 seconds to 3 minutes.

**Patentansprüche**

**1.** Verfahren zum Schätzen eines Gesundheitszustands, SoH, einer Lithium-Schwefel-Batterie, umfassend die folgenden Schritte:

a) Halten einer Batterie, die vollständig geladen ist und für die ein SoH bestätigt werden soll, in einem Ruhezustand für 0,01 Sekunden oder mehr;
b) Messen einer Leerlaufspannung, $OCV_{(det)}$, in einem Zustand, in dem ein Spannungsabfall während des Ruhezustands vorgenommen wird;
c) Berechnen von $\Delta OCV$ durch Subtrahieren der $OCV_{(det)}$ von $OCV_{(ini)}$, wobei $OCV_{(ini)}$ zuvor auf die gleiche Weise wie in den Schritten a) und b) in einem Anfangsstadium der Verwendung der Batterie gemessen wurde; und
d) Schätzen eines SoH [%] der Batterie aus einem Wert des $\Delta OCV$.

**2.** Verfahren nach Anspruch 1, wobei das Schätzen des SoH [%] der Batterie in Schritt d) unter Verwendung einer negativen Korrelationsfunktion zwischen dem SoH [%] der Batterie und dem Wert von $\Delta OCV$ durchgeführt wird.

3. Verfahren nach Anspruch 1, wobei das Schätzen des SoH [%] der Batterie in Schritt d) durch ein Verfahren zum Vergleichen des gemessenen ∆OCV mit einer SoH-Abbildungsreferenz der Batterie, die im Voraus hergestellt wurde und dem Wert von ∆OCV entspricht, durchgeführt wird.

4. Verfahren nach Anspruch 3, wobei die SoH-Abbildungsreferenz der Batterie, die dem Wert von ∆OCV entspricht, Daten sind, die durch wiederholtes vollständiges Laden und vollständiges Entladen einer anderen Batterie, die auf die gleiche Weise wie die Batterie hergestellt wurde, erzeugt werden, um SoH-Daten der anderen Batterie gemäß Gleichung 1 in jedem Lade-/Entladezyklus zu erhalten,

Erhalten von ∆OCV-Daten auf die gleiche Weise wie vorstehend, und
Abgleichen dieser Daten miteinander auf eine Eins-zu-Eins-Weise,

**[Gleichung 1]**

$$SoH\ [\%] = [C_{(det)}\ /C_{(ini)}] \times 100$$

wobei $C_{(ini)}$ sich auf eine nutzbare Kapazität der Batterie bezieht, bevor sie verschlechtert wird, und $C_{(det)}$ sich auf eine nutzbare Kapazität der Batterie bezieht, nachdem sie verschlechtert wurde.

5. Verfahren nach Anspruch 4, wobei die SoH-Abbildungsreferenz ein Graph ist, der SoH auf einer y-Achse und den Wert von ∆OCV auf einer x-Achse oder eine Nachschlagetabelle zeigt, in der SoH und der Wert von ∆OCV, der SoH entspricht, miteinander auf eine Eins-zu-Eins-Weise abgeglichen werden.

6. Verfahren nach Anspruch 1, wobei das Anfangsstadium in Schritt c) von einer ersten Verwendung der Batterie bis zu einem Zeitpunkt reicht, wenn eine Verschlechterungsrate der Batterie innerhalb von 10 % liegt.

7. Verfahren nach Anspruch 1, wobei das Schätzen des SoH [%] der Batterie aus dem Wert von ∆OCV in Schritt d) durch ein Verfahren durchgeführt wird, das Folgendes umfasst:

Erhalten eines Streudiagrammgraphen unter Verwendung von SoH-Daten einer anderen Batterie, die auf die gleiche Weise wie die Batterie hergestellt wurde, wobei die SoH-Daten der anderen Batterie in jedem Zyklus durch wiederholtes vollständiges Laden und vollständiges Entladen für die Batterie als einen y-Achsenwert und unter Verwendung von ∆OCV-Daten, die auf die gleiche Weise wie vorstehend erhalten wurden, als einen x-Achsenwert erhalten werden,
Erhalten einer Anpassungsfunktion durch Anwenden der Methode der kleinsten Quadrate auf den Streudiagrammgraphen und
Ersetzen von ∆OCV, das aus der Lithium-Schwefel-Batterie erhalten wurde, in die Anpassungsfunktion.

8. Verfahren nach Anspruch 1, wobei das Schätzen des SoH [%] der Batterie aus dem Wert von ∆OCV in Schritt d) durch die folgende Gleichung 2 durchgeführt wird:

**[Gleichung 2]**

$$SoH\ [\%] = \sum_{i=1}^{j} \left[ a_i \left( OCV_{(ini)} - OCV_{(det)} \right)^i \right] + c$$

wobei

$OCV_{(ini)}$ eine Leerlaufspannung ist, die gemessen wird, nachdem die Batterie in dem Ruhezustand für einen Zeitraum von 0,01 Sekunden oder mehr in dem Anfangsstadium der Verwendung der Batterie gehalten wurde,
die $OCV_{(det)}$ die Leerlaufspannung ist, die gemessen wird, nachdem die Batterie in dem Ruhezustand für den gleichen Zeitraum wie der Ruhezustandshaltezeitraum in dem Zustand, in dem die Batterie vollständig geladen ist, gehalten wurde,
j die höchste Dimension einer Polynomfunktion ist,
$a_i$ ein Koeffizient eines $i$-ten-Ordnung-Terms ist, und
c ein Wert von SoH [%] ist, der $OCV_{(ini)}$ entspricht.

**9.** Verfahren nach Anspruch 1, wobei der Ruhezustand in Schritt a) für 0,01 Sekunden bis 3 Minuten gehalten wird.

**Revendications**

**1.** Procédé destiné à estimer un état de santé, (State de Health (SoH)), d'une batterie au lithium-soufre, comprenant les étapes consistant à :

a) maintenir une batterie, qui est complétement chargée et pour laquelle un état de santé (SoH) doit être confirmé, à un état de repos pendant 0,01 seconde ou plus ;
b) mesurer une tension à circuit ouvert (Open Circuit Voltage (OCV)), $OCV_{(det)}$ dans un état dans lequel une baisse de tension est effectuée pendant l'état de repos ;
c) calculer $\Delta OCV$ en soustrayant la $OCV_{(det)}$ de $OCV_{(ini)}$, où $OCV_{(ini)}$ a été mesurée précédemment de la même manière qu'aux étapes a) et b) à un stade initial d'utilisation de ladite batterie ; et
d) estimer un $SoH$ [%] de ladite batterie à partir d'une amplitude de la $\Delta OCV$.

**2.** Procédé selon la revendication 1, dans lequel l'estimation du $SoH$ [%] de ladite batterie à l'étape d) est effectuée en utilisant une fonction de corrélation négative entre le $SoH$ [%] de ladite batterie et l'amplitude de $\Delta OCV$.

**3.** Procédé selon la revendication 1, dans lequel l'estimation du $SoH$ [%] de ladite batterie à l'étape d) est effectuée par un procédé de comparaison de la $\Delta OCV$ mesurée avec une cartographie de référence d'état de santé (SoH) de ladite batterie préparée à l'avance et correspondant à l'amplitude de $\Delta OCV$.

**4.** Procédé selon la revendication 3, dans lequel la cartographie de référence d'état de santé (SoH) de ladite batterie correspondant à l'amplitude de $\Delta OCV$ est les données créées en répétant une charge complète et une décharge complète d'une autre batterie fabriquée de la même manière que ladite batterie pour obtenir les données d'état de santé (SoH) de ladite autre batterie selon l'Équation 1 dans chaque cycle de charge/décharge,

obtenir des données de $\Delta OCV$ de la même manière que la manière ci-dessus, et
faire correspondre ces données les unes aux autres de manière univoque,

[Équation 1]

$$SoH\ [\%] = [C_{(det)} / C_{(ini)}] \times 100$$

dans lequel $C_{(ini)}$ fait référence à une capacité utilisable de la batterie avant d'être détériorée, et $C_{(det)}$ fait référence à une capacité utilisable de la batterie après avoir été détériorée.

**5.** Procédé selon la revendication 4, dans lequel la cartographie de référence d'état de santé (SoH) est un graphique montrant l'état de santé (SoH) sur un axe y et l'amplitude de $\Delta OCV$ sur un axe x ou une table de consultation dans laquelle l'état de santé (SoH) et l'amplitude de $\Delta OCV$ correspondant à l'état de santé (SoH) sont appariés l'un à l'autre de manière univoque.

**6.** Procédé selon la revendication 1, dans lequel le stade initial à l'étape c) est à partir d'une première utilisation de ladite batterie à un point dans le temps où un taux de détérioration de la batterie est dans une fourchette de 10 %.

**7.** Procédé selon la revendication 1, dans lequel l'estimation du $SoH$ [%] de ladite batterie à partir de l'amplitude de $\Delta OCV$ à l'étape d) est effectuée par un procédé consistant à :

obtenir un diagramme de dispersion en utilisant les données d'état de santé (SoH) d'une autre batterie fabriquée de la même manière que ladite batterie, dans lequel les données d'état de santé (SoH) de l'autre batterie sont obtenues dans chaque cycle en répétant une charge complète et une décharge complète pour la batterie qu'une valeur d'un axe y et en utilisant les données $\Delta OCV$ obtenues de la même manière qu'une valeur d'un axe x ci-dessus,
obtenir une fonction d'ajustement en appliquant la méthode des moindres carrés au diagramme de dispersion, et
substituer la $\Delta OCV$ obtenue de la batterie au lithium-soufre dans la fonction d'ajustement.

**8.** Procédé selon la revendication 1, dans lequel l'estimation du *SoH* [%] de ladite batterie à partir de l'amplitude de *ΔOCV* à l'étape d) est effectuée par l'Équation 2 ci-après :

**[Equation 2]**

$$SoH\ [\%] = \sum_{i=1}^{j} \left[ a_i \left( OCV_{(ini)} - OCV_{(det)} \right)^i \right] + c$$

dans laquelle,

> $OCV_{(ini)}$ *est* une tension à circuit ouvert mesurée après que ladite batterie a été maintenue à l'état de repos pendant une période de 0,01 seconde ou plus au stade initial de l'utilisation de ladite batterie,
> la $OCV_{(det)}$ est la tension à circuit ouvert mesurée après que ladite batterie a été maintenue à l'état de repos pendant ladite même période que la période maintenant l'état de repos dans laquelle ladite batterie est complétement chargée,
> *j* est la dimension la plus grande d'une fonction polynomiale,
> $a_i$ est un coefficient d'un *i*-ème terme d'ordre, et
> c est une valeur de *SoH* [%] correspondant à $OCV_{(ini)}$.

**9.** Procédé selon la revendication 1, l'état de repos à l'étape a) est maintenu pendant 0,01 seconde to 3 minutes.

【Figure 1】

【Figure 2】

【Figure 3】

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016166555 A1

- WO 2019240225 A1